# EUROPEAN PATENT APPLICATION

(11) **EP 2 775 525 A1**
(43) Date of publication of application: **10.09.2014**
(21) Application number: 14157610.8
(22) Date of filing: 04.03.2014
(51) Int. Cl.: H01L 27/146, H04N 5/355, H01L 21/266

(54) **High dynamic range pixel having a plurality of photodiodes with a single implant**

(30) Priority: 04.03.2013 US 201313784351
(71) Applicant: OmniVision Technologies, Inc., Santa Clara, CA 95054 (US)
(72) Inventor: Chen, Gang, San Jose, CA California 95132 (US); Yang, Dajiang, San Jose, CA California 95122 (US); Li, Jin, San Jose, CA California 95129 (US); Mao, Duli, Sunnyvale, CA California 94087 (US); Tai, Dyson H., San Jose, CA California 95129 (US)
(74) Representative: Hackney, Nigel John

(57) **Abstract**

A high dynamic range image sensor pixel includes a short integration photodiode and a long integration photodiode disposed in semiconductor material. The long integration photodiode has a light exposure area that is substantially larger than a light exposure area of the short integration photodiode. The light exposure area of the short integration photodiode has a first doping concentration from a first doping implantation. The light exposure area of the long integration photodiode includes at least one implanted portion having the first doping concentration from the first doping implantation. The light exposure area of the long integration photodiode further includes at least one non-implanted portion photomasked from the first doping implantation such that a combined doping concentration of the implanted and non-implanted portions of the light exposure area of the long integration photodiode is less than the first doping concentration of the light exposure area of the short integration photodiode.

## Description

### BACKGROUND INFORMATION

### Field of the Disclosure

The present invention is generally related to high dynamic range image sensors, and more specifically, the present invention is directed to high dynamic range image sensors having a plurality of photodiodes in each pixel.

### Background

High dynamic range (HDR) image sensors are useful for many applications. In general, ordinary image sensors, including for example charge coupled device (CCD) and complementary metal oxide semiconductor (CMOS) image sensors, have a dynamic range of approximately 70 dB dynamic range. In comparison, the human eye has a dynamic range of up to approximately 100 dB. There are a variety of situation in which an image sensor having an increased dynamic range is beneficial. For example, image sensors having a dynamic range of more than 100 dB dynamic range are needed in the automotive industry are necessary in order to handle different driving conditions, such as driving from a dark tunnel into bright sunlight. Indeed, many applications may require image sensors with at least 90 dB of dynamic range or more to accommodate a wide range of lighting situations, varying from low light conditions to bright light conditions.

One known approach for implementing HDR image sensors is to use a combination of a photodiodes in each pixel. One of the photodiodes can be used to sense bright light conditions while another photodiode can be used to sense low light conditions. However, one challenge with manufacturing HDR image sensors using this approach is that additional photo masking and implantation steps are required during manufacture, which add to the overall complexity and cost of implementing the HDR image sensors. Furthermore, the additional photomasking and implantation steps result in lower yields of HDR image sensors that are manufactured using this approach.

### BRIEF DESCRIPTION OF THE DRAWINGS

Non-limiting and non-exhaustive embodiments of the present invention are described with reference to the following figures, wherein like reference numerals refer to like parts throughout the various views unless otherwise specified.
**FIG. 1** is a diagram illustrating one example of an imaging system including an example HDR image sensor in accordance with the teachings of the present invention.
**FIG. 2** is a schematic illustrating one example of an HDR pixel including a plurality of photodiodes in accordance with the teachings of the present invention.
**FIG. 3A** illustrates a top down view of one example of an HDR pixel included in an example pixel array having multiple implantations.
**FIG. 3B** illustrates a top down view of one example of an HDR pixel included in an example pixel array having a single implantation in accordance with the teachings of the present invention.
**FIGs. 4A-4E** illustrate various other examples of a long integration photodiodes included in example HDR pixels having at least one implanted portion and at least one non-implanted portion in accordance with the teachings of the present invention.

Corresponding reference characters indicate corresponding components throughout the several views of the drawings. Skilled artisans will appreciate that elements in the figures are illustrated for simplicity and clarity and have not necessarily been drawn to scale. For example, the dimensions of some of the elements in the figures may be exaggerated relative to other elements to help to improve understanding of various embodiments of the present invention. Also, common but well-understood elements that are useful or necessary in a commercially feasible embodiment are often not depicted in order to facilitate a less obstructed view of these various embodiments of the present invention.

### DETAILED DESCRIPTION

In the following description, numerous specific details are set forth in order to provide a thorough understanding of the present invention. It will be apparent, however, to one having ordinary skill in the art that the specific detail need not be employed to practice the present invention. In other instances, well-known materials or methods have not been described in detail in order to avoid obscuring the present invention.

Reference throughout this specification to "one embodiment", "an embodiment", "one example" or "an example" means that a particular feature, structure or characteristic described in connection with the embodiment or example is included in at least one embodiment of the present invention. Thus, appearances of the phrases "in one embodiment", "in an embodiment", "one example" or "an example" in various places throughout this specification are not necessarily all referring to the same embodiment or example. Furthermore, the particular features, structures or characteristics may be combined in any suitable combinations and/or subcombinations in one or more embodiments or examples. Particular features, structures or characteristics may be included in an integrated circuit, an electronic circuit, a combinational logic circuit, or other suitable components that provide the described functionality. In addition, it is appreciated that the figures provided herewith are for explanation purposes to persons ordinarily skilled in the art and that the drawings are not necessarily drawn to scale.

Examples in accordance with the teaching of the present invention describe an image sensor pixel for use in a high dynamic range (HDR) image sensor, including at least a short integration photodiode and a long integration photodiode. In various examples, the short integration photodiode has a smaller light exposure area and a higher overall doping concentration compared to the long integration photodiode of the pixel. As will be described, examples of the short integration photodiode and a long integration photodiode are realized using a single implantation step in accordance with the teachings of the present invention. Since separate implantation steps and associated photomasking steps for the short integration photodiode and a long integration photodiode are combined, the overall complexity and cost of manufacturing an HDR image sensor is reduced accordance with the teachings of the present invention. Furthermore, the reduced of the number of photomasking and implantation steps required for manufacture also results in increased yields of HDR image sensors in accordance with the teachings of the present invention.

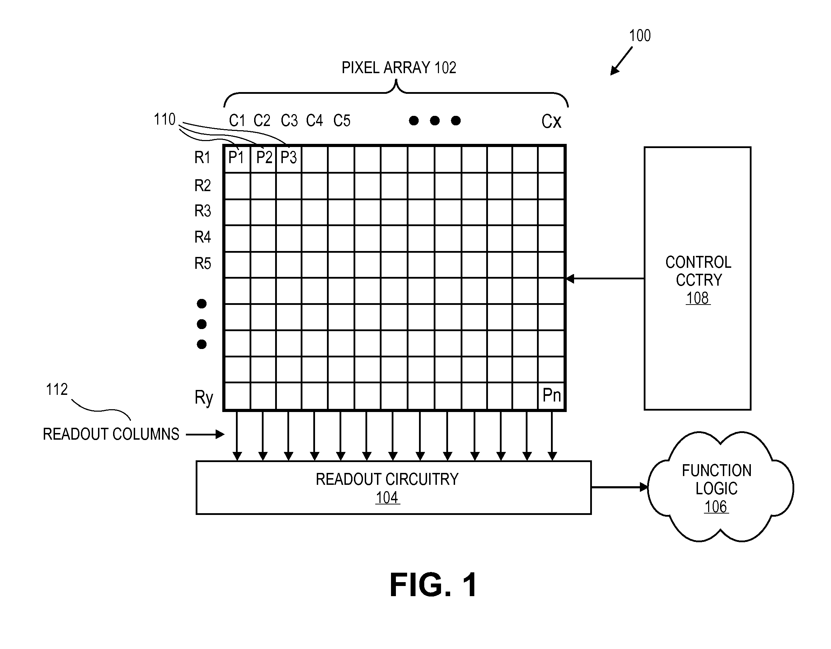

To illustrate, **FIG. 1** is a diagram that shows generally one example of an HDR imaging system 100 including an example pixel array 102 having pixels that include at least a short integration photodiode and a long integration photodiode in accordance with the teachings of the present invention. In the example, the short integration photodiode of each pixel has a smaller light exposure area and a higher overall doping concentration compared to the long integration photodiode of the pixel. In the depicted example, the short integration photodiode and the long integration photodiode are realized using a single implantation step in accordance with the teachings of the present invention. As shown in the depicted example, HDR imaging system 100 includes pixel array 102 coupled to control circuitry 108 and readout circuitry 104, which is coupled to function logic 106.

In one example, pixel array 102 is a two-dimensional (2D) array of imaging sensors or pixels 110 (e.g., pixels P1, P2 ..., Pn). In one example, each pixel 110 is a CMOS imaging pixel including at least a short integration photodiode and a long integration photodiode. In the depicted example, short integration photodiode of each pixel 110 has a smaller light exposure area and a higher overall doping concentration compared to the long integration photodiode of the pixel 110. As illustrated, each pixel 110 is arranged into a row (e.g., rows R1 to Ry) and a column (e.g., column C1 to Cx) to acquire image data of a person, place, object, etc., which can then be used to render an image of the person, place, object, etc.

In one example, after each pixel 110 has acquired its image data or image charge, the image data is read out by readout circuitry 104 through readout columns 112 and then transferred to function logic 106. In various examples, readout circuitry 104 may include amplification circuitry, analog-to-digital (ADC) conversion circuitry, or otherwise. Function logic 106 may simply store the image data or even manipulate the image data by applying post image effects (e.g., crop, rotate, remove red eye, adjust brightness, adjust contrast, or otherwise). In one example, readout circuitry 104 may read out a row of image data at a time along readout column lines (illustrated) or may read out the image data using a variety of other techniques (not illustrated), such as a serial read out or a full parallel read out of all pixels simultaneously.

In one example, control circuitry 108 is coupled to pixel array 102 to control operational characteristics of pixel array 102. For example, control circuitry 108 may generate a shutter signal for controlling image acquisition. In one example, the shutter signal is a global shutter signal for simultaneously enabling all pixels within pixel array 102 to simultaneously capture their respective image data during a single acquisition window. In another example, the shutter signal is a rolling shutter signal such that each row, column, or group of pixels is sequentially enabled during consecutive acquisition windows.

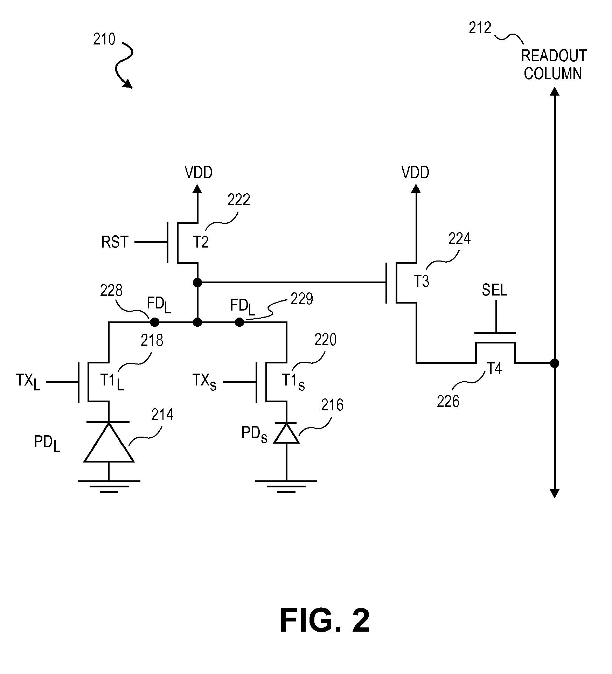

FIG. 2 is a schematic illustrating one example of a pixel 210 in accordance with the teachings of the present invention. In one example, it is appreciated that pixel 210 may be one of the plurality of pixels 110 included in the example pixel array 102 of the HDR image sensor 100 illustrated above in **FIG. 1****.** As shown in the example depicted in **FIG. 2****,** pixel 210 includes a short integration photodiode PD_{S} 216 and a long integration photodiode PD_{L} 214. As will be discussed in further detail below, long integration photodiode PD_{L} 214 has a larger light exposure area than the light exposure area of short integration photodiode PD_{S} 216. Thus, long integration photodiode PD_{L} 214 has higher sensitivity to incident light and is therefore utilized for lower light intensity sensing. Since short integration photodiode PD_{S} 216 on the other hand has less light exposure area, it is less sensitive to light compared to long integration photodiode PD_{L} 214, and is therefore utilized for higher light intensity sensing. By utilizing both long integration photodiode PD_{L} 214 and short integration photodiode PD_{S} 216 in pixel 210, HDR imaging sensing is realized in accordance with the teaching of the present invention.

Continuing with example depicted in **FIG. 2****,** charge that is accumulated in long integration photodiode PD_{L} 214 is switched through transfer transistor T1_{L} 218 to a floating drain FD_{L} 228 in response to a control signal TX_{L} and charge that is accumulated in short integration photodiode PD_{S} 216 is switched through transfer transistor T1_{S} 2220 to a floating drain FD_{S} 229 in response to a control signal TX_{S}. In one example, the floating drains FD_{L} 228 and FD_{S} 229 are each physically located near their respective transfer transistors T1_{L} 218 and T1_{S} 220.

As shown in the example, pixel 210 also includes an amplifier transistor T3 224 that has a gate terminal coupled to floating drain FD_{L} 228 and floating drain FD_{S} 229. Thus, in the illustrated example, the charge from long integration photodiode PD_{L} 214 and short integration photodiode PD_{S} 216 are separately switched to floating drain FD_{L} 228 and floating drain FD_{S} 229, respectively, which share the same amplifier transistor T3 224. In one example, amplifier transistor T3 224 is coupled in a source follower configuration as shown, which therefore amplifies an input signal at the gate terminal of amplifier transistor T3 224 to an output signal at the source terminal of amplifier transistor T3 224. As shown, row select transistor T4 226 is coupled to the source terminal of amplifier transistor T3 224 to selectively switch the output of amplifier transistor T3 231 to readout column 212 in response to a control signal SEL. As shown in the example, pixel 210 also includes reset transistor 241 coupled to floating drain FD 228, long integration photodiode PD_{L} 214 and short integration photodiode PD_{S} 216, which may be used to reset charge accumulated in pixel 210 in response to a reset signal RST. In one example, the charge accumulated in floating drain FD 228, long integration photodiode PD_{L} 214 and short integration photodiode PD_{S} 216 can be reset during an initialization period of pixel 210, or for example each time after charge information has been read out from pixel 210 and prior to accumulating charge in long integration photodiode PD_{L} 214 and short integration photodiode PD_{S} 216 for the acquisition of a new HDR image in accordance with the teachings of the present invention.

In one example, long integration photodiode PD_{L} 214 and short integration photodiode PD_{S} 216 are designed to have either photodiode appear to have the same electrical characteristics to amplifier transistor T3 224 for improved performance of pixel 210. Separate implantation steps are typically performed to individually tailor the electrical characteristics of long integration photodiode PD_{L} 214 and short integration photodiode PD_{S} 216 to compensate for the substantial difference in light exposure areas between long integration photodiode PD_{L} 214 and short integration photodiode PD_{S} 216.

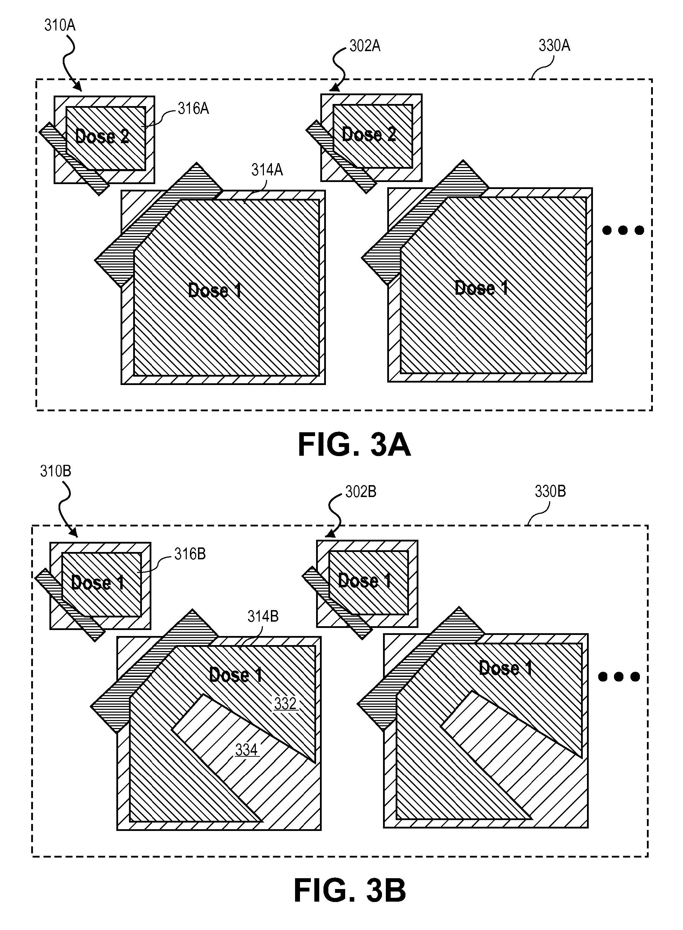

To illustrate, **FIG. 3A** shows a top down view of a portion of a pixel 310A included a pixel array 302A. In the example, pixel 310A includes a long integration photodiode 314A and short integration photodiode 316A disposed in semiconductor material 330A. As shown in the depicted example, the light exposure area of long integration photodiode 314A is substantially larger than the light exposure area of short integration photodiode 316A. As a result, long integration photodiode 314A has higher light sensitivity for lower light intensity sensing and short integration photodiode 316A has lower light sensitivity for higher light intensity sensing.

In order for long integration photodiode 314A and short integration photodiode 316A to have the same electrical characteristics with respect to the corresponding amplifier transistor (e.g., amplifier transistor T3 224 of **FIG. 2****),** the doping concentration of long integration photodiode 314A is less than the doping concentration of short integration photodiode 316A. As such, the full well charge capacities of long integration photodiode 314A and short integration photodiode 316A are comparable to compensate for the substantial difference in area between long integration photodiode 314A and short integration photodiode 316A.

In order to realize the different doping concentrations for long integration photodiode 314A and short integration photodiode 316A, the dopants are implanted for short integration photodiode 316A and long integration photodiode 314A in separate implantation steps for pixel 310A. That is, the dopants for long integration photodiode 314A are implanted using a separate and lower implant dose (e.g., shown as "Dose 1" in **FIG. 3A****)** compared to a higher implant dose (e.g., shown as "Dose 2" in FIG. 3A) in short integration photodiode 316A. Consequently, there are also separate photomasking steps corresponding to the separate implantation (e.g., "Dose 1" and "Dose 2") for long integration photodiode 314A and short integration photodiode 316A. Using the separate photomasking and implantation steps as described for long integration photodiode 314A and short integration photodiode 316A as illustrated in **FIG. 3A****,** the resulting implant dose for one example of short integration photodiode 316A is in a range between 4x10¹² cm⁻² and 6x10¹² cm⁻² and the resulting implant dose for one example of long integration photodiode 314A is in a range between 2x10¹² cm⁻² and 4x10¹² cm⁻². It is appreciated that with the separate photomasking and implantation steps performed to realize long integration photodiode 314A and short integration photodiode 316A, the overall complexity and cost to manufacture pixel 310A is increased with each additional step. Furthermore, the additional photomasking and implantation steps result in lower yields for pixel 310A.

**FIG. 3B** shows a top down view of a portion of a pixel 310B in a pixel array 302B in accordance with the teachings of the present invention. In the example, pixel 310B includes a long integration photodiode 314B and short integration photodiode 316B disposed in semiconductor material 330B. As shown in the depicted example, the light exposure area of long integration photodiode 314A is substantially larger than the light exposure area of short integration photodiode 316A. As a result, long integration photodiode 314A has higher light sensitivity for lower light intensity sensing and short integration photodiode 316A has lower light sensitivity for higher light intensity sensing. In one example, it is appreciated that pixel 310B may be pixel 210 of **FIG. 2****,** or one of the plurality of pixels 110 included in the example pixel array 102 of the HDR image sensor 100 illustrated above in **FIG. 1****.** As shown in the example depicted in **FIG. 3B****,** the light exposure area of long integration photodiode 314B is substantially larger than the light exposure area of short integration photodiode 316B such that long integration photodiode 314B has higher light sensitivity for lower light intensity sensing and short integration photodiode 316B has lower light sensitivity for higher light intensity sensing in accordance with the teachings of the present invention.

As illustrated the depicted example, the light exposure area of long integration photodiode 314B is shaped to include at least one implanted portion 332 and at least one non-implanted portion 334 in accordance with the teachings of the present invention. In the depicted example, the at least one implanted portion 332 of long integration photodiode 314B is implanted with dopants during the same single implantation step in which the short integration photodiode 316B is implanted with dopants (e.g., "Dose 1" as illustrated in **FIG. 3B****)** in accordance with the teachings of the present invention. Accordingly, in one example, the implant dose of short integration photodiode 316B as well as the implant dose of the at least one implanted portion 332 of long integration photodiode 314B are both in a range between 4x10¹² cm⁻² and 6x10¹² cm⁻².

However, since long integration photodiode 314B also includes at least one non-implanted portion 334, which was shielded from being implanted with dopants during the single implantation step in which the short integration photodiode 316B and implanted portion 332 were implanted with dopants (e.g., "Dose 1"), the combined doping concentration of the at least one implanted portion 332 and the at least one non-implanted portion 334 of the long integration photodiode 314B is less than the doping concentration of short integration photodiode 316B. In one example, where the mean implant depth is about one micrometer, the combined doping concentration of implanted portion 332 and non-implanted portion 334 of long integration photodiode 314B in **FIG. 3B** is in a range between 2x10¹⁶ cm⁻³ and 4x10¹⁶ cm⁻³. Thus, in the illustrated example, the full well charge capacity of the short integration photodiode 316B is substantially equal to the full well charge capacity of the long integration photodiode 314B, even though the area of the long integration photodiode 314B is substantially larger than the area of short integration photodiode 316B in accordance with the teachings of the present invention.

During operation, the at least one non-implanted portion 334 of long integration photodiode 314B is small enough such that the at least one non-implanted portion 334 remains depleted of charge carriers during image acquisition. That is, the larger long integration photodiode 314B still acts like a larger area photodetector with corresponding higher sensitivity to low light, while the full well charge capacity and charge gain of long integration photodiode 314B appear to the amplifier (e.g. amplifier transistor T3 224 of **FIG. 2****)** to be more like the smaller short integration photodiode 316B in accordance with the teachings of the present invention.

Therefore, it is appreciated that since both short integration photodiode 316B and the at least one implanted portion 332 of long integration photodiode 314B are photomasked and implanted using the same combined photomasking and implantation steps, the overall number of steps to manufacture pixel 310B is reduced since separate photomasking and implantation steps are no longer needed to form short integration photodiode 316 and long integration photodiode 314B in accordance with the teachings of the present invention. As a result, the overall complexity and cost to manufacture pixel 310B is reduced. Furthermore, with fewer photomasking and implantation steps needed in order to manufacture pixel 310B, increased yields may be realized for pixel 310B in accordance with the teachings of the present invention.

It is appreciated that the examples of implant dose ranges of between 4x10¹² cm⁻² and 6x10¹² cm⁻² and between 2x10¹² cm⁻² and 4x10¹² cm⁻² are provided above for explanation purposes and that other implant doses may be utilized to realize pixel 310B in accordance with he the teachings of the present invention.

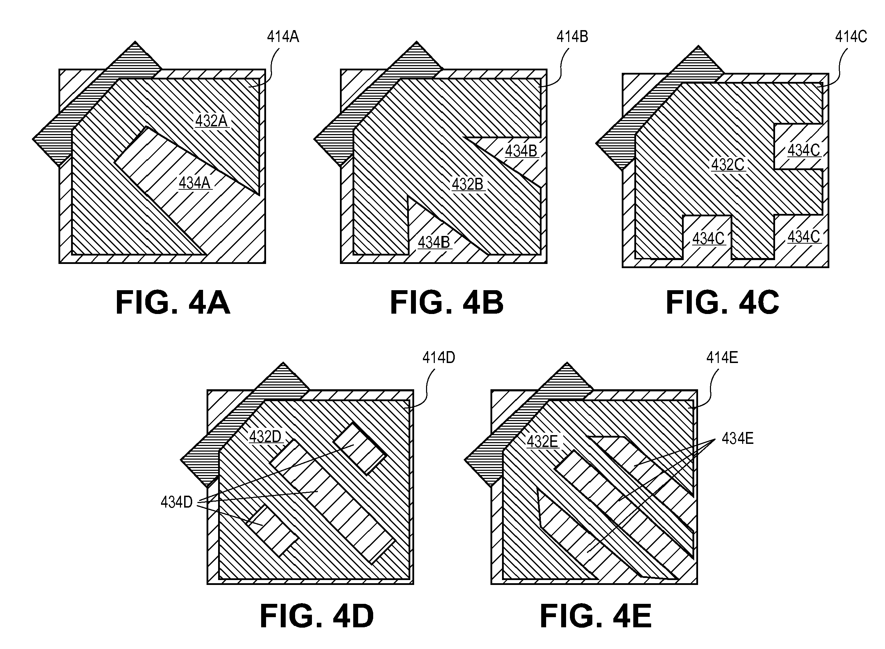

**FIGs. 4A-4E** illustrate various possible examples of long integration photodiodes 414A, 414B, 414C, 414D and 414E, respectively, which may be included in an example HDR pixel having at least one implanted portion and at least one non-implanted portion in accordance with the teachings of the present invention. It is appreciated that any of the long integration photodiodes 414A, 414B, 414C, 414D and 414E as shown in **FIGs. 4A-4E****,** respectively, may be used in place of example long integration photodiode 314B of **FIG. 3****B.**

In the example depicted in **FIG. 4A****,** the at least one implanted portion 432A of long integration photodiode 414A is photomasked and implanted with dopants at the same time in which the corresponding short integration photodiode (e.g., short integration photodiode 316B of **FIG. 3B****)** is photomasked and implanted with dopants. As shown in the example, the photomask used to form the at least one implanted portion 432A results in at least one non-implanted portion 434A in long integration photodiode 414A as shown. In the example depicted in **FIG. 4A****,** the at least one non-implanted portion 434A extends from one corner towards an opposite corner of long integration photodiode 414A as shown. Since the at least one non-implanted portion 434A is shielded from being implanted with dopants while the at least one implanted portion 432A is implanted with dopants, the doping concentration of the at least one non-implanted portion 434A is less than the doping concentration of the at least one implanted portion 432A. Therefore, the combined doping concentration of the at least one implanted portion 432A and the at least one non-implanted portion 434A is less than the doping concentration of the at least one implanted portion 432A in accordance with the teachings of the present invention.

Similarly, as shown the example depicted in **FIG. 4B****,** the at least one implanted portion 432B of long integration photodiode 414B is photomasked and implanted with dopants at the same time in which the corresponding short integration photodiode (e.g., short integration photodiode 316B of **FIG. 3B****)** is photomasked and implanted with dopants. As shown in the example, the photomask used to form the at least one implanted portion 432B results in non-implanted portions 434B in long integration photodiode 414B as shown. In the example depicted in **FIG. 4B****,** the non-implanted portions 434B extend from two adjacent sides of long integration photodiode 414B towards respective opposite sides of long integration photodiode 414B as shown. Since the non-implanted portions 434B are shielded from being implanted with dopants while the at least one implanted portion 432B is implanted with dopants, the doping concentration of the non-implanted portions 434B is less than the doping concentration of the at least one implanted portion 432B. Therefore, the combined doping concentration of the at least one implanted portion 432B and the non-implanted portions 434B is less than the doping concentration of the at least one implanted portion 432B in accordance with the teachings of the present invention.

Similarly, as shown the example depicted in **FIG. 4C****,** the at least one implanted portion 432C of long integration photodiode 414C is photomasked and implanted with dopants at the same time in which the corresponding short integration photodiode (e.g., short integration photodiode 316B of **FIG. 3B****)** is photomasked and implanted with dopants. As shown in the example, the photomask used to form the at least one implanted portion 432C results in non-implanted portions 434C in long integration photodiode 414C as shown. In the example depicted in **FIG. 4C****,** the non-implanted portions 434C extend from a corner and two sides of long integration photodiode 414C towards the center of long integration photodiode 414C as shown. Since the non-implanted portions 434C are shielded from being implanted with dopants while the at least one implanted portion 432C is implanted with dopants, the doping concentration of the non-implanted portions 434C is less than the doping concentration of the at least one implanted portion 432C. Therefore, the combined doping concentration of the at least one implanted portion 432C and the non-implanted portions 434C is less than the doping concentration of the at least one implanted portion 432C in accordance with the teachings of the present invention.

Similarly, as shown the example depicted in **FIG. 4D****,** the at least one implanted portion 432D of long integration photodiode 414D is photomasked and implanted with dopants at the same time in which the corresponding short integration photodiode (e.g., short integration photodiode 316B of **FIG. 3B****)** is photomasked and implanted with dopants. As shown in the example, the photomask used to form the at least one implanted portion 432D results in non-implanted portions 434D in long integration photodiode 414D as shown. In the example depicted in **FIG. 4D****,** the non-implanted portions 434D include a plurality of regions enclosed entirely within the at least one implanted portion 432D of long integration photodiode 414D as shown. Since the non-implanted portions 434D are shielded from being implanted with dopants while the at least one implanted portion 432D is implanted with dopants, the doping concentration of the non-implanted portions 434D is less than the doping concentration of the at least one implanted portion 432D. Therefore, the combined doping concentration of the at least one implanted portion 432D and the non-implanted portions 434D is less than the doping concentration of the at least one implanted portion 432D in accordance with the teachings of the present invention.

Similarly, as shown the example depicted in FIG. 4E, the at least one implanted portion 432E of long integration photodiode 414E is photomasked and implanted with dopants at the same time in which the corresponding short integration photodiode (e.g., short integration photodiode 316B of **FIG. 3B****)** is photomasked and implanted with dopants. As shown in the example, the photomask used to form the at least one implanted portion 432E results in non-implanted portions 434E in long integration photodiode 414E as shown. In the example depicted in **FIG. 4E****,** the non-implanted portions 434E include a plurality of regions that extend from one corner towards an opposite corner of long integration photodiode 414E as shown. Since the non-implanted portions 434E are shielded from being implanted with dopants while the at least one implanted portion 432E is implanted with dopants, the doping concentration of the non-implanted portions 434E is less than the doping concentration of the at least one implanted portion 432E. Therefore, the combined doping concentration of the at least one implanted portion 432E and the non-implanted portions 434E is less than the doping concentration of the at least one implanted portion 432E in accordance with the teachings of the present invention.

It is appreciated that the examples depicted in **FIGs. 4A-4E** are provided for explanation purposes and that other shapes for the implanted and non-implanted portions in a long integration photodiode may be utilized in accordance with the teachings of the present invention.

The above description of illustrated examples of the present invention, including what is described in the Abstract, are not intended to be exhaustive or to be limitation to the precise forms disclosed. While specific embodiments of, and examples for, the invention are described herein for illustrative purposes, various equivalent modifications are possible without departing from the broader spirit and scope of the present invention.

These modifications can be made to examples of the invention in light of the above detailed description. The terms used in the following claims should not be construed to limit the invention to the specific embodiments disclosed in the specification and the claims. Rather, the scope is to be determined entirely by the following claims, which are to be construed in accordance with established doctrines of claim interpretation. The present specification and figures are accordingly to be regarded as illustrative rather than restrictive.

## Claims

1. An image sensor pixel for use in a high dynamic range image sensor, comprising:
a short integration photodiode disposed in semiconductor material, the short integration photodiode having a first light exposure area, wherein the first light exposure area has a first doping concentration from a first doping implantation; and
a long integration photodiode disposed in the semiconductor material, the long integration photodiode having a second light exposure area, wherein the second light exposure area is substantially larger than the first light exposure area, wherein the second light exposure area includes at least one implanted portion having the first doping concentration from the first doping implantation, wherein the second light exposure area further includes at least one non-implanted portion photomasked from the first doping implantation such that a combined doping concentration of the implanted and non-implanted portions of the second light exposure area is less than the first doping concentration of the first light exposure area.

2. The image sensor pixel of claim 1 wherein a charge capacity of the short integration photodiode is substantially equal to a charge capacity of the long integration photodiode.

3. The image sensor pixel of claim 1 wherein the long integration photodiode has greater sensitivity to light than the short integration diode.

4. The image sensor pixel of claim 1 wherein the at least one non-implanted portion of the second light exposure area remains substantially depleted of charge carriers during image collection.

5. The image sensor pixel of claim 1 further comprising first and second floating drains disposed in the semiconductor material coupled to the short integration photodiode and the long integration photodiode through first and second transfer transistors, respectively, wherein the first and second transfer transistors are separately switched.

6. The image sensor pixel of claim 5 further comprising a reset transistor disposed in the semiconductor material coupled to the first and second floating drains.

7. The image sensor pixel of claim 5 further comprising an amplifier transistor disposed in the semiconductor material coupled to the first and second floating drains.

8. The image sensor pixel of claim 7 further comprising a select transistor disposed in the semiconductor material between the amplifier transistor and a readout column line.

9. A high dynamic range imaging system, comprising:
a pixel array having a plurality of image sensor pixels, wherein each one of the plurality of image sensor pixels is according to any one of the above claims
control circuitry coupled to the pixel array to control operation of the pixel array; and
readout circuitry coupled to the pixel array to readout image data from the plurality of image sensor pixels.

10. The imaging system of claim 9 further comprising function logic coupled to the readout circuitry to store the image data readout from the plurality of image sensor pixels.
